Europäisches Patentamt

European Patent Office

Office européen des brevets

(19)

(11) Veröffentlichungsnummer : **0 027 674**
**B1**

(12) **EUROPÄISCHE PATENTSCHRIFT**

(45) Veröffentlichungstag der Patentschrift :
**01.06.83**

(21) Anmeldenummer : **80200973.8**

(22) Anmeldetag : **15.10.80**

(51) Int. Cl.³ : **H 01 F 1/34, C 30 B 33/00,
C 30 B 29/28**

(54) **Verfahren zur Herstellung eines Scheibenresonators mit einem Einkristall aus magnetischem Granatmaterial.**

(30) Priorität : **17.10.79 DE 2941994**

(43) Veröffentlichungstag der Anmeldung :
**29.04.81 Patentblatt 81/17**

(45) Bekanntmachung des Hinweises auf die Patenterteilung : **01.06.83 Patentblatt 83/22**

(84) Benannte Vertragsstaaten :
**DE FR GB IT**

(56) Entgegenhaltungen :
**FR A 2 326 770
US A 3 759 745
IEEE TRANSACTIONS ON MAGNETICS, Band
MAG-14, Nr. 5, 1978, P. ROSCHMANN et al. :
« Annealing effects on cation distribution in diamagnetically substituted single crystal yttrium
iron garnet »**

(73) Patentinhaber : **Philips Patentverwaltung GmbH
Steindamm 94
D-2000 Hamburg 1 (DE)
DE
N.V. Philips' Gloeilampenfabrieken
Groenewoudseweg 1
NL-5621 BA Eindhoven (NL)
FR GB IT**

(72) Erfinder : **Röschmann, Peter
Steenbalken 13
D-2000 Hamburg 63 (DE)**

(74) Vertreter : **Nehmzow-David, Fritzi-Maria, et al
Philips Patentverwaltung GmbH Steindamm 94
D-2000 Hamburg 1 (DE)**

EP 0 027 674 B1

Verfahren zur Herstellung eines Scheibenresonators mit einem Einkristall aus magnetischem Granat-material

Die Erfindung betrifft ein Verfahren zur Herstellung eines Scheibenresonators mit einem Einkristall aus magnetischem Granatmaterial der Zusammensetzung $Y_3(Fe_{2-x}M_x)$ $(Fe_{3-y}M_y)O_{12}$, worin M ein nichtmagnetisches Ion ist, das sowohl oktaedrische als auch tetraedrische Gitterplätze besetzen kann, mit folgenden Verfahrensschritten :

Züchtung eines Einkristalls aus dem magnetischen Granatmaterial ;

Schneiden des Einkristalls in einer definierten Kristallrichtung in dünne Scheiben mit einem Verhältnis von Dicke zu Durchmesser kleiner als etwa 0,3 und

Temperbehandlung der Einkristallscheiben.

Im Vergleich zu konventionellen Kugelresonatoren, die als ferrimagnetische Resonatoren für abstimmbare Oszillatoren und Filter im VHF-, UHF- und SHF-Wellenbereich verwendet werden, weisen Scheibenresonatoren aus monokristallinem Yttrium-Eisen-Granat, insbesondere, wenn dieser mit Gallium oder Aluminium oder einem anderen nichtmagnetischen Ion, das sowohl oktaedrische als auch tetraedrische Gitterplätze besetzen kann, substituiert ist, einige Vorteile auf. Axial magnetisierte Scheibenresonatoren können prinzipiell bei niedrigeren Resonanzfrequenzen betrieben werden als aus dem gleichen Material gefertigte Kugelresonatoren.

Ferner tritt in Scheibenresonatoren keine Verkoppelung der ferrimagnetischen Resonanz mit entarteten magnetostatischen Resonanzmoden auf, während bei Kugelresonatoren dieser Effekt unterhalb etwa 1,5 GHz beträchtliche Probleme aufwirft und zu einer hohen Ausschußquote führt. Ein Nachteil von YIG-Scheibenresonatoren ist allerdings deren große Temperaturabhängigkeit der Resonanzfrequenz. Bei Kugelresonatoren dagegen kann die Temperaturabhängigkeit der Resonanzfrequenz $f_r$ durch eine entsprechende Kristallographische Orientierung auf Werte von nahezu Null für einen bestimmten Betriebsfrequenzbereich eingestellt werden. Diese Möglichkeit besteht nicht für einen Scheibenresonator nach Schneiden der Scheibe aus dem Ausgangskristall, denn das Resonanzfeld $H_z$ muß parallel zur Achse der Scheibe ausgerichtet sein. Durch geeignete Auswahl der Schnittebene am Ga : YIG-Ausgangskristall kann jedoch sichergestellt werden, daß der Beitrag des Anisotropiefeldes zur Temperaturabhängigkeit unter umgekehrten Vorzeichen zum Beitrag der Entmagnetisierung steht. Bei Ga : YIG tritt dies ein als Folge der negativen Kristallanisotropie, wenn die [111]-Richtung in der Scheibenachse liegt. Ein Scheibenresonator aus diesem Material hat demzufolge eine im wesentlichen temperaturunabhängige Resonanzfrequenz innerhalb eines gegebenen Temperaturbereiches.

Im Prinzip kann der Wert der Kompensationstemperatur der Resonanzfrequenz $T_0$ bei einem Scheibenresonator aus einem vorgegebenen Ausgangskristall bis zu einem gewissen Grad durch Auswahl des Verhältnisses von Dicke d zu Durchmesser D der Scheibe beeinflußt werden.

In der Praxis kann diese Bezugsgröße nur in beschränktem Umfang herangezogen werden, da sowohl die Dicke als auch der Durchmesser der Einkristallscheiben hauptsächlich den Hochfrequenz-Koppelfaktor des Scheibenresonators in der Schaltung, in der er eingesetzt ist, bestimmt.

Bei den mit ferrimagnetischen Resonatoren aufgebauten Bauteilen ist das erlaubte Temperaturverhalten der Resonanzfrequenz im Betriebsfrequenzbereich durch jeweils verschiedenartige Systemanforderungen festgelegt. Damit ergibt sich bei Verwendung von Scheibenresonatoren eine enge Toleranzforderung für den Wert für die Gallium-Gesamtsubstitution z, wenn Scheibenresonatoren verwendet werden, bei denen für unterschiedliche Spezifikationen von $T_0$ bzw. des Verhältnisses d/D jeweils ein anderer bestimmter Wert von z erforderlich ist.

Die Forderung nach einem genau einzuhaltenden Wert von z für eine gewünschte Kompensationstemperatur der Resonanzfrequenz $T_0$ ist in der Praxis nur schwer zu erfüllen, da die bekannten Kristallzüchtungsverfahren für Ga : YIG eine Vorherbestimmung des Wertes für z nur im Toleranzrahmen von etwa ± 10 % mit den sich daraus ergebenden $T_0$-Werten von etwa $T_0$ ± 40 °C erlaubt.

Der Erfindung liegt die Aufgabe zugrunde, ein Verfahren für die Einstellung des Temperaturkoeffizienten der Resonanzfrequenz von substituierten YIG-Scheibenresonatoren anzugeben, derart, daß die Resonatoren einen Temperaturkoeffizienten von nahezu Null bei einer gewünschten Betriebstemperatur aufweisen.

Diese Aufgabe wird erfindungsgemäß dadurch gelöst, daß — zum Erreichen eines Temperaturkoeffizienten der Resonanzfrequenz von etwa Null innerhalb eines gewünschten Temperaturbereiches — eine nicht-getemperte Einkristallscheibe mit einem Temperaturkoeffizienten der Resonanzfrequenz von etwa Null bei einer Temperatur oberhalb des gewünschten Temperaturbereiches der Temperbehandlung bei höheren Temperaturen und im umgekehrten Fall bei niedrigeren Temperaturen in bezug auf eine Referenztemperatur unterzogen wird.

Nach einer weiteren vorteilhaften Ausbildung der Erfindung werden die höheren Temperaturen für die Temperbehandlung im Temperaturbereich von etwa 850 °C bis etwa 1 400 °C und die niedrigeren Temperaturen im Temperaturbereich von etwa 400 °C bis etwa 850 °C gewählt.

Nach einer weiteren Ausgestaltung der Erfindung wird für M als nichtmagnetisches Ion Ga oder Al eingesetzt.

Die mit der Erfindung erzielten Vorteile bestehen insbesondere darin, daß der Temperaturkoeffizient der Resonanzfrequenz eines Scheibenresonators bei einer gewünschten Temperatur $T_0$

mit nahezu Null eingestellt werden kann bei freier Wahl von $T_o$ innerhalb eines Temperaturbereiches bis zu 120 °C.

a) für unterschiedliche d/D-Verhältnisse bei Scheiben aus demselben Ga : YIG-Kristall und damit freie Wahl des Hochfrequenz-Koppelfaktors ;

b) für Scheiben aus Ga : YIG-Kristallen mit unterschiedlichen Werten für die Gallium-Substitution ; damit ergeben sich kleine Ausschußquoten.

Ein weiterer Vorteil ist die Kompensationsmöglichkeit sonstiger externer temperaturabhängiger Einflüsse auf die Resonanzfrequenz.

Die genannten Vorteile sind zum Teil eine wesentliche Voraussetzung für die Verwendbarkeit von YIG-Scheiben-resonatoren in der Serienfertigung abstimmbarer Oszillatoren und Filter für z. B. Betriebsfrequenzen von etwa 500 MHz bis etwa 1 500 MHz.

Anhand der Zeichnung wird ein Ausführungsbeispiel der Erfindung beschrieben und ihre Wirkungsweise erläutert.

Es zeigen

Figur 1 die Abhängigkeit der Resonanzfrequenz $f_r$ von der Temperatur T für eine ungetemperte Scheibe und die Verschiebung dieser Kurve nach Tempern bei zwei unterschiedlichen Temperaturen,

Figur 2 die Abhängigkeit der Kompensationstemperatur $T_o$ von der Tempertemperatur $T_G$ für Scheiben mit unterschiedlichen Werten für die Gallium-Gesamtsubstitution z.

Eine Scheibe eines Durchmessers von 3 mm und einer Dicke von 0,1 mm wurde von einem Ga : YIG-Ausgangskristall, der einen Wert für die Gallium-Gesamtsubstitution z von 0,88 Formeleinheiten hatte, in der Weise geschnitten, daß die [111]-Richtung des Kristalls sich parallel zur Normalen auf die Scheibe erstreckt. Die Temperaturabhängigkeit der Resonanzfrequenz der Scheibe wurde bestimmt mit Hilfe von Reflexionsmessungen mittels eines Wobbelgenerators bei konstantem Magnetfeld senkrecht zur Scheibe.

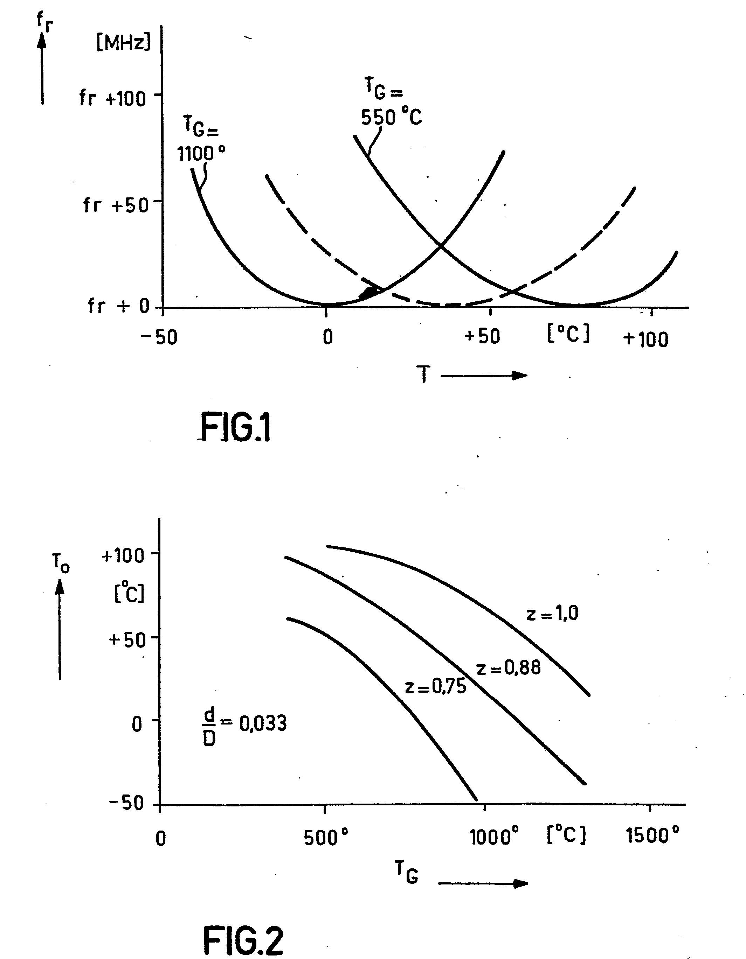

In Figur 1 ist die Änderung der Resonanzfrequenz $f_r$ mit der Temperatur für eine nicht-getemperte Scheibe (gestrichelte Linie) und die Änderung der Resonanzfrequenz mit der Temperatur für Scheiben, die bei einer Temperatur $T_G$ von 1 100 °C respektive 550 °C getempert wurden, dargestellt. Die Kompensationstemperatur $T_o$ der Resonanzfrequenz wird durch die Temperbehandlung demnach um ca. ± 40 °C vom Wert $T_o \simeq 40$ °C für die nichtgetemperte Scheibe verschoben.

Figur 2 zeigt die Abhängigkeit der Kompensationstemperatur $T_o$ von der Tempertemperatur $T_G$ für Scheiben mit einem Verhältnis ihrer Dicke d zu ihrem Durchmesser D von d/D = 0,033 und mit Werten für die Gallium-Gesamtsubstitution von jeweils z = 0,75 ; 0,88 und 1,0 Formeleinheiten (z = x + y).

Die aufgezeigten Änderungen von $T_o$ durch die Temperbehandlung sind reversibel.

In der Praxis ist die Temperbehandlung im Temperaturbereich von etwa 400 °C bis etwa 1 400 °C durchführbar. Dabei ist eine Verschiebung der Kompensationstemperatur um mehr als 100 °C möglich.

## Ansprüche

1. Verfahren zur Herstellung eines Scheibenresonators mit einem Einkristall aus magnetischem Granatmaterial der Zusammensetzung $Y_3(Fe_{2-x}M_x)$ $(Fe_{3-y}M_y)O_{12}$, worin M ein nichtmagnetisches Ion ist, das sowohl oktaedrische als auch tetraedrische Gitterplätze besetzen kann, mit folgenden Verfahrensschritten :

Züchtung eines Einkristalls aus dem magnetischen Granatmaterial ;

Schneiden des Einkristalls in einer definierten Kristallrichtung in dünne Scheiben mit einem Verhältnis von Dicke zu Durchmesser kleiner als etwa 0,3 und

Temperbehandlung der Einkristallscheiben, dadurch gekennzeichnet, daß — zum Erreichen eines Temperaturkoeffizienten der Resonanzfrequenz von etwa Null innerhalb eines gewünschten Temperaturbereiches — eine nichtgetemperte Einkristallscheibe mit einem Temperaturkoeffizienten der Resonanzfrequenz von etwa Null bei einer Temperatur oberhalb des gewünschten Temperaturbereiches der Temperbehandlung bei höheren Temperaturen und im umgekehrten Fall bei niedrigeren Temperaturen in bezug auf eine Referenztemperatur unterzogen wird.

2. Verfahren nach Anspruch 1, dadurch gekennzeichnet, daß die höheren Temperaturen für die Temperbehandlung im Temperaturbereich von 850 °C bis 1 400 °C und die niedrigeren Temperaturen im Temperaturbereich von 400 °C bis 850 °C gewählt werden.

3. Verfahren nach Anspruch 1, dadurch gekennzeichnet, daß für M als nichtmagnetisches Ion Ga oder Al eingesetzt wird.

## Claims

1. A method of manufacturing a disc resonator having a single crystal of a magnetic garnet material of the composition $Y_3(Fe_{2-x}M_x)$ $(Fe_{3-y}M_y)O_{12}$, wherein M is a nonmagnetic ion which can occupy both octahedral and tetrahedral lattice sites, comprising the following steps :

growing a single crystal of a magnetic garnet material,

cutting the single crystal in a given crystal direction into thin discs having a ratio of the thickness to the diameter smaller than approximately 0.3,

and subjecting the monocrystalline discs to an annealing treatment, characterized in that in order to obtain a temperature coefficient of the resonant frequency of approximately zero within a desired temperature range, an unannealed monocrystalline disc having a temperature coefficient of the resonant frequency of approximately zero at a temperature above the desired temperature range is subjected to an annealing treatment at higher temperatures and in the reverse case is subjected to an annealing treatment at lower temperatures relative to a reference temperature.

2. A method as claimed in Claim 1, characterized in that the higher temperatures for the annealing treatment are chosen in the temperature range from 850 °C to 1 400 °C and the lower temperatures are chosen in the temperature range from 400 °C to 850 °C.

3. A method as claimed in Claim 1, characterized in that Ga or Al is used for M as a nonmagnetic ion.

**Revendications**

1. Procédé permettant de préparer un résonateur à disque avec un monocristal en un grenat magnétique de la composition $Y_3(Fe_{2-x}M_x)$ $(Fe_{3-y}M_y)O_{12}$, formule dans laquelle M est un ion non magnétique pouvant occuper tant des positions de réseau octaédriques que tétraédriques, présentant les stades de réalisation suivants :

croissance d'un monocristal en un grenat magnétique ;

coupage du monocristal dans une direction cristalline défini en disques minces, dont le rapport entre l'épaisseur et le diamètre est inférieur à environ 0,3 et

traitement thermique du disque monocristallin, caractérisé en ce que pour atteindre un coefficient de température de la fréquence de résonance d'environ 0 dans une gamme de températures désirée — dans le cas d'une température supérieure à la gamme de températures désirée, un disque monocristallin non thermiquement traité présentant un coefficient de température de la fréquence de résonance égal à environ 0 est soumis à un traitement thermique à des températures supérieures et, dans le cas inverse, à des températures inférieures par rapport à une température de référence.

2. Procédé selon la revendication 1, caractérisé en ce que les températures supérieures pour le traitement thermique sont choisies dans la gamme de températures de 850 °C et 1 400 °C et les températures inférieures dans la gamme de températures de 400 °C à 850 °C.

3. Procédé selon la revendication 1, caractérisé en ce que pour M comme ion non magnétique est utilisé Ga ou Al.

FIG.1

FIG.2